(19) Europäisches Patentamt
European Patent Office
Office européen des brevets

(11) **EP 4 439 181 A1**

(12) **EUROPEAN PATENT APPLICATION**

(43) Date of publication:
**02.10.2024 Bulletin 2024/40**

(21) Application number: **23166036.6**

(22) Date of filing: **31.03.2023**

(51) International Patent Classification (IPC):
**G03F 9/00** *(2006.01)*     **G03F 7/00** *(2006.01)*

(52) Cooperative Patent Classification (CPC):
**G03F 9/7046; G03F 7/706837**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventors:
• **MAYANK, Mayank**
  **5500 AH Veldhoven (NL)**
• **HULSEBOS, Edo, Maria**
  **5500 AH Veldhoven (NL)**
• **ROOZE, Joost**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **A METHOD FOR MODELING MEASUREMENT DATA OVER A SUBSTRATE AREA AND ASSOCIATED APPARATUSES**

(57)    Disclosed is a method for modeling measurement data over a substrate area and associated apparatus. The method comprises obtaining substrate measurement data describing spatial variation of a substrate parameter; and fitting a model to said substrate measurement data to obtain a fitted model; wherein said fitting step comprises regularizing the fitting using a plurality of regularization parameters, said plurality of regularization parameters having been individually optimized to penalize spatial components of said substrate measurement data in accordance with their effect on a parameter of interest.

Fig. 4

EP 4 439 181 A1

**Description**

FIELD

The present disclosure relates to processing of substrates for the production of, for example, semiconductor devices.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use radiation. The wavelength of this radiation determines the minimum size of features which can be formed on the substrate. Typical wavelengths currently in use are about 365 nm (i-line), about 248 nm, about 193 nm and about 13 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of about 193 nm.

Low-k1 lithography may be used to process features with dimensions smaller than the classical resolution limit of a lithographic apparatus. In such a process, the resolution formula may be expressed as CD = $k1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of a numerical aperture (NA,) a customized illumination scheme, use of one or more phase shifting patterning devices, optimization of the design layout such as optical proximity correction (OPC) in the design layout, or other methods generally defined as resolution enhancement techniques (RET). Additionally or alternatively, one or more tight control loops for controlling a stability of the lithographic apparatus may be used to improve reproduction of the pattern at low k1.

Effectiveness of the control of a lithographic apparatus may depend on characteristics of individual substrates. For example, a first substrate processed by a first processing tool prior to processing by the lithographic apparatus (or any other process step of the manufacturing process, herein referred to generically as a manufacturing process step) may benefit from (slightly) different control parameters than a second substrate processed by a second processing tool prior to processing by the lithographic apparatus.

The accurate placement of patterns on the substrate is a chief challenge for reducing the size of circuit components and other products that may be produced by lithography. In particular, the challenge of measuring accurately the features on a substrate which have already been laid down is a critical step in being able to align successive layers of features in superposition accurately enough to produce working devices with a high yield. So-called overlay should, in general, be achieved within a few tens of nanometers in today's sub-micron semiconductor devices, down to a few nanometers in the most critical layers.

Consequently, modern lithography apparatuses involve extensive measurement or 'mapping' operations prior to the step of actually exposing or otherwise patterning the substrate at a target location. So-called advanced alignment models have been and continue to be developed to model and correct more accurately non-linear distortions of the wafer 'grid' that are caused by processing steps and/or by the lithographic apparatus itself. Not all distortions are correctable during exposure, however, and it remains important to trace and eliminate as many causes of such distortions as possible.

These distortions of the wafer grid are represented by measurement data associated with mark position. The measurement data are obtained from measurements of wafers. An example of such measurements are alignment measurements of alignment marks performed using an alignment system in a lithographic apparatus prior to exposure. Another example of such measurements are overlay measurements of overlay targets performed using a metrology system after exposure.

To improve fitting and prevent overfitting of a model (e.g., an alignment model) to the measured data (e.g., alignment data), regularization may be employed. It is desirable to improve present regularization techniques.

## SUMMARY

In a first aspect of the invention there is provided a method for modeling substrate measurement data relating to a substrate in a lithographic process, the method comprising: obtaining substrate measurement data describing spatial variation of a substrate parameter; and fitting a model to said substrate measurement data to obtain a fitted model; wherein said fitting step comprises regularizing the fitting using a plurality of regularization parameters, said plurality of regularization parameters having been individually optimized to penalize spatial components of said substrate measurement data in accordance with their effect on a parameter of interest.

In a further aspect of the invention, there is provided a computer program comprising program instructions operable to perform the method of the first aspect when run on a suitable apparatus, and associated processing apparatus and lithographic apparatus.

## BRIEF DESCRIPTION OF THE DRAWINGS

Embodiments of the invention will now be described, by way of example only, with reference to the accompanying schematic drawings, in which:

> Figure 1 depicts a schematic overview of a lithographic apparatus;
> Figure 2 depicts a schematic overview of a lithographic cell;
> Figure 3 shows schematically the use of the lithographic apparatus and lithographic cell of Figures 1 and 2 together with one or more other apparatuses forming a manufacturing facility for, e.g., semiconductor devices, the facility implementing a control strategy according to an embodiment of the invention; and
> Figure 4 is a flowchart describing a method according to an embodiment of the invention.

## DETAILED DESCRIPTION

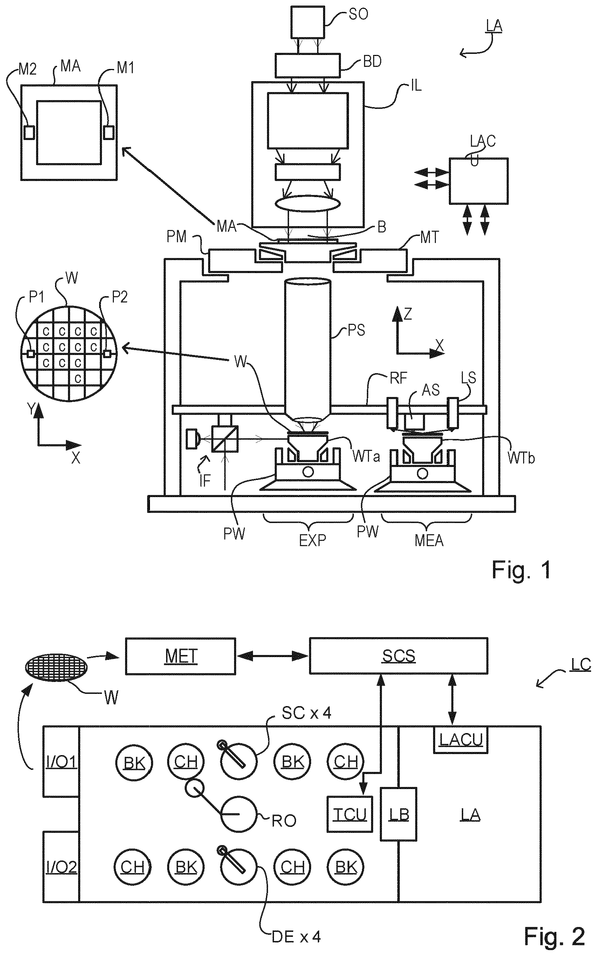

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a support (e.g., a mask table) T constructed to support a patterning device (e.g., a mask) MA and connected to a first positioner PM configured to accurately position the patterning device MA in accordance with certain parameters, one or more substrate supports (e.g., a wafer table) WTa and WTb constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in U.S. Patent No. 6,952,253, which is incorporated herein by reference.

Lithographic apparatus LA in this example is of a so-called dual stage type which has two substrate tables WTa and WTb and two stations - an exposure station and a measurement station-between which the substrate tables can be moved. While one substrate on one substrate table is being exposed at the exposure station EXP, another substrate can be loaded onto the other substrate table at, e.g., the measurement station MEA or at another location (not shown) or can be processed at measurement station MEA. A substrate table with a substrate can be located at measurement station MEA so that various preparatory steps may be carried out. The preparatory steps may include mapping the surface height of the substrate using a level sensor LS and/or measuring the position of alignment marks on the substrate using an alignment sensor AS. The alignment marks are arranged nominally in a regular grid pattern. However, due to inaccuracies in creating the marks and also due to deformations of the substrate that occur throughout its processing, the marks may deviate from the ideal grid. Consequently, in addition to measuring position and orientation of the substrate, the alignment sensor in practice may measure in detail the positions of many marks across the substrate area, if the apparatus LA is to print product features at the correct locations with high accuracy. The measurement of alignment marks can therefore be time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. An embodiment of the invention can be applied in an apparatus with only one substrate table, or with more than two.

In addition to having one or more substrate supports, the lithographic apparatus LA may comprise a measurement stage (not shown). The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

The radiation beam B is incident on the patterning device (e.g., mask) MA, which is held on the support structure (e.g., mask table) MT, and is patterned by the patterning device. Having traversed the patterning device MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WTa/WTb can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WTa/WTb may be realized using a long-stroke module and a short-stroke module, which form part of the second positioner PW. In the case of a stepper (as opposed to a scanner) the support structure MT may be connected to a short-stroke actuator only, or may be fixed. Patterning device MA and substrate W may be aligned using patterning device alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device MA, the patterning device alignment marks may be located between the dies.

The apparatus further includes a lithographic apparatus control unit LACU which controls all the movements and measurements of various actuators and sensors of the lithographic apparatus (such as those described). Control unit LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus. For example, one processing subsystem may be dedicated to servo control of the substrate positioner PW. Separate units may even handle coarse and fine actuators, or different axes. Another unit might be dedicated to the readout of the position sensor IF. Overall control of the apparatus may be controlled by a central processing unit, communicating with these sub-systems processing units, with operators and with other apparatuses involved in the lithographic manufacturing process.

As shown in Figure 2 the lithographic apparatus LA may form part of a lithographic cell LC, also sometimes referred to as a lithocell or (litho)cluster, which often also includes apparatuses to perform pre- and post-exposure processes on a substrate W. Conventionally these apparatuses includes one or more spin coaters SC to deposit resist layers, one or more developers DE to develop exposed resist, one or more chill plates CH and one or more bake plates BK, e.g. for conditioning the temperature of substrates W e.g. for conditioning solvents in the resist layers. A substrate handler, or robot, RO picks up substrates W from input/output ports I/O1, I/O2, moves them between the different processing apparatuses and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, one or more inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus MET, which may also be referred to as a metrology apparatus or metrology tool, is used to determine one or more properties of the substrates W, and in particular, how one or more properties of different substrates W vary or how one or more properties associated with different layers of the same substrate W vary from layer to layer. The inspection apparatus may be constructed to identify defects on the substrate W and may, for example, be part of the lithocell LC, or may be integrated into the lithographic apparatus LA, or may even be a stand-alone device. The inspection apparatus may measure the one or more properties on a latent image (an image in a resist layer after the exposure), or on a semi-latent image (an image in a resist layer after a post-exposure bake step), or on a developed resist image (in which the exposed or unexposed parts of the resist have been removed), or even on an etched image (after a pattern transfer step such as etching).

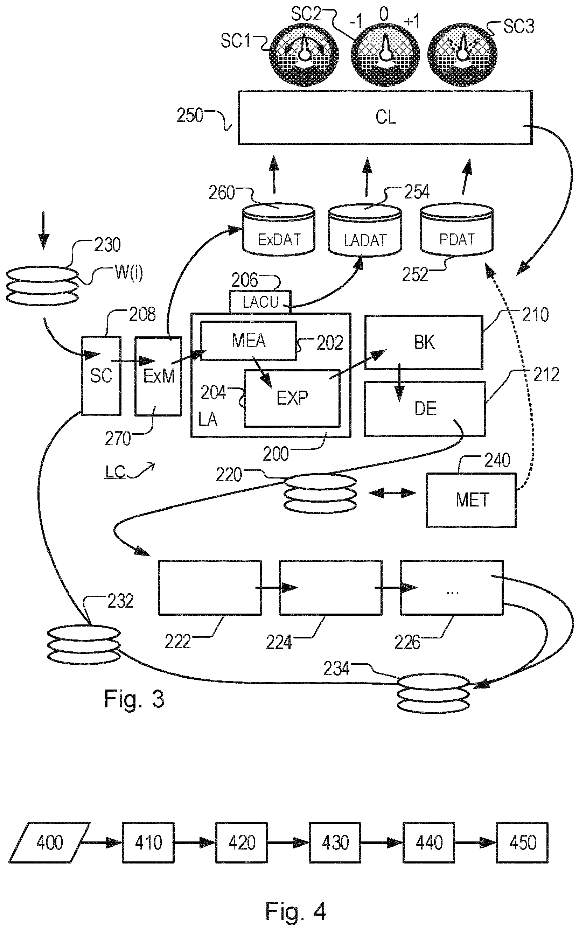

Figure 3 shows the lithographic apparatus LA and the lithocell LC in the context of an industrial manufacturing facility for, e.g., semiconductor products. Within the lithographic apparatus (or "litho tool" 200 for short), the measurement station MEA is shown at 202 and the exposure station EXP is shown at 204. The control unit LACU is shown at 206. As already described, litho tool 200 forms part of a "litho cell" or "litho cluster" that also includes a coating apparatus SC, 208 for applying photosensitive resist and/or one or more other coatings to substrate W for patterning by the apparatus 200. At the output side of apparatus 200, a baking apparatus BK, 210 and developing apparatus DE, 212 are provided for developing the exposed pattern into a physical resist pattern. Other components shown in Figure 3 are omitted, for clarity.

Once the pattern has been applied and developed, patterned substrates 220 are transferred to other processing apparatuses such as are illustrated at 222, 224, 226. A wide range of processing steps are implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses.

The described semiconductor manufacturing process comprising a sequence of patterning process steps is just one example of an industrial process in which the techniques disclosed herein may be applied. The semiconductor manufacturing process includes a series of patterning steps. Each patterning process step includes a patterning operation, for example a lithographic patterning operation, and a number of other chemical and/or physical operations.

The manufacture of semiconductor devices involves many repetitions of such processing, to build up device structures with appropriate materials and patterns, layer-by-layer on the substrate. Modern device manufacturing processes may comprise 40 or 50 individual patterning steps, for example. Accordingly, substrates 230 arriving at the litho cluster may be newly prepared substrates, or they may be substrates that have been processed previously in this cluster 232 or in another apparatus entirely. Similarly, depending on the required processing, substrates on leaving apparatus 226 may be returned for a subsequent patterning operation in the same litho cluster (such as substrates 232), they may be destined for patterning operations in a different cluster (such as substrates 234), or they may be finished products to be sent for dicing and packaging (such as substrates 234).

Each layer of the product structure typically involves a different set of process steps, and the apparatuses used at each layer may be completely different in type. Further, even where the processing steps to be applied by the apparatuses are nominally the same, in a large facility, there may be several supposedly identical machines working in parallel to perform the processing on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. Parallel processing may also be performed in different chambers within a larger apparatus. Moreover, in practice, different layers often involve different etch processes, for example chemical etch, plasma etch, etc., according to the details of the material to be etched, and special requirements such as, for example, anisotropic etching.

The previous and/or subsequent processes may be performed in other lithography apparatuses, as just mentioned, and may even be performed in different types of lithography apparatus. For example, one or more layers in the device manufacturing process which are very demanding in terms of, e.g., resolution and/or overlay may be performed in a more advanced lithography tool than one or more other layers that are less demanding. Therefore, one or more layers may be exposed in an immersion type lithography tool, while one or more others are exposed in a 'dry' tool. One or more layers may be exposed in a tool working at DUV wavelengths, while one or more others are exposed using EUV wavelength radiation.

Also shown in Figure 3 is the metrology apparatus (MET) 240 which is provided for making measurements of parameters of the products at desired stages in the manufacturing process. A common example of a metrology station in a modern lithographic manufacturing facility is a scatterometer, for example an angle-resolved scatterometer or a spectroscopic scatterometer, and it may be applied to measure one or more properties of developed substrates at 220 prior to etching in the apparatus 222. Using metrology apparatus 240, performance parameter data PDAT 252 may be determined. From this performance parameter data PDAT 252, it may be further determined that a performance parameter, such as overlay or critical dimension (CD), does not meet specified accuracy requirements in the developed resist. Prior to the etching step, the opportunity exists to strip the developed resist and reprocess one or more of the substrates 220 through the litho cluster. Moreover, the metrology results from the metrology apparatus 240 can be used to maintain accurate performance of the patterning operations in the litho cluster, by making small adjustments over time, thereby reducing or minimizing the risk of products being made out-of-specification, and requiring re-work. Of course, metrology apparatus 240 and/or one or more other metrology apparatuses (not shown) can be applied to measure one or more properties of the processed substrates 232, 234, and/or of incoming substrates 230.

Typically the patterning process in a lithographic apparatus LA is one of the most significant steps in the processing which involves high accuracy of dimensioning and placement of structures on the substrate W. To help ensure this high accuracy, three systems may be combined in a control environment as schematically depicted in Figure 3. One of these systems is the litho tool 200 which is (virtually) connected to a metrology apparatus 240 (a second system) and to a computer system CL 250 (a third system). A desire of such an environment is to optimize or improve the cooperation between these three systems to enhance an overall so-called "process window" and provide one or more tight control loops to help ensure that the patterning performed by the lithographic apparatus LA stays within a process window. The process window defines a range of values of a plurality of process parameters (e.g. two or more selected from dose, focus, overlay, etc.) within which a specific manufacturing process yields a defined result (e.g. a functional semiconductor device) - typically a range within which the values of the process parameters in the lithographic process or patterning process are allowed to vary while yielding a proper structure (e.g., specified in terms of an acceptable range of CD (such as +- 10% of a nominal CD)).

The computer system CL may use (part of) the design layout to be patterned to predict which one or more resolution enhancement techniques to use and to perform computational lithography simulations and calculations to determine which patterning device layout and lithographic apparatus settings achieve a largest overall process window of the patterning process (depicted in Figure 3 by the double arrow in the first dial SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second dial SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third dial SC3).

Computer system 250 can implement control of the process based on a combination of (i) "pre-processing metrology data" (e.g., including scanner metrology data LADAT 254, and External pre-processing metrology ExDAT 260), associated with substrates before they are processed in a given processing step (for example a lithography step) and (ii) performance data or "post-processing data" PDAT 252 that is associated with the substrates after they have been processed.

A first set of pre-processing metrology data LADAT 254 (referred to herein as scanner metrology data, as it is data generated by the lithographic apparatus LA 200 or scanner) may comprise the alignment data conventionally obtained by the lithographic apparatus LA 200 using alignment sensor AS in the measurement station 202. Alternatively, or in addition to the alignment data, the scanner metrology data LADAT 254 may include height data obtained using level sensor LS, and/or "wafer quality" signals from the alignment sensor AS or the like. As such, the scanner metrology data LADAT 254 may comprise an alignment grid for the substrate, and data relating to substrate deformation (flatness). For example, the scanner metrology data LADAT 254 may be generated by the measurement station MEA 202 of twin stage lithographic apparatus LA 200 (e.g., as this typically comprises the alignment sensor and leveling sensor) in advance of exposure, enabling simultaneous measurement and exposure operations. Such twin stage lithographic apparatus are well known.

Stand-alone alignment tools or external pre-exposure metrology tools ExM 270 may also (optionally) be used to make measurements before exposure on a lithographic apparatus. Such external pre-exposure metrology tools ExM 270 are distinct from the measurement station MEA 202 of a twin stage lithographic apparatus LA 200. Any of the measurement data or alignment data described herein may be measured by such an external pre-exposure metrology tool as an alternative or in addition to an alignment tool within a scanner or lithographic apparatus.

While Figure 3 shows separate storage 252, 254, 260 for each of the performance data PDAT, scanner metrology data LADAT and external pre-exposure data ExDAT, it will be appreciated that these different types of data may be stored in one common storage unit, or may be distributed over a larger number of storage units, from which particular items of data can be retrieved when required.

To represent alignment measurements over a wafer and/or over a field, an alignment model is used. A first purpose of an alignment model is to provide a mechanism for interpolating and/or extrapolating the available measurements data over the whole wafer, such that an expose grid can be created on each die. The measurement data will be sparse as it is simply not practical to measure as many measurement regions as would be desirable from a modeling perspective: the time and therefore throughput overhead would be too high. A second purpose of an alignment model is to provide noise suppression. This may be achieved by using fewer model parameters than measurements.

While standard models (e.g., linear models) might use fewer than ten parameters, advanced alignment models typically use more than 15 parameters, or more than 30 parameters. Examples of advanced models are higher order wafer alignment (HOWA) models, zone-alignment (ZA) models and radial basis function (RBF) based alignment models. HOWA is a published technique based on second, third and higher order polynomial functions. RBF modeling is described in US2012218533A1, which is incorporated herein by reference and essentially comprises an interpolation method, e.g., based on radial-based thin plate splines. Different versions and extensions of these advanced models can be devised. The advanced models generate a complex description of the wafer grid that is corrected for, during the exposure of the target layer. RBF and latest versions of HOWA provide particularly complex descriptions based on tens of parameters. This implies a great many measurements are required to obtain a wafer grid with sufficient detail.

US2012218533A1 describes a RBF modeling method which comprises the steps of using measured locations of the marks to generate radial basis functions, and calculating model parameters of said substrate within said apparatus using the generated radial basis functions as a basis function across said substrate. RBFs $\phi(\vec{x}, \vec{c})$ are real-valued functions whose value depend only on the distance from the origin, or alternatively on the distance $x$ from some other point, called center $c$, so that:

$$\phi(\vec{x}, \vec{c}) = \phi(\|\vec{x} - \vec{c}\|) = \phi(r)$$

Function approximation with RBFs may be built in the form:

$$y(\tilde{x}) = \sum_{i=1}^{N} w_i \, \phi(\|\vec{x} - \vec{c}\|)$$

where the approximating function $y(\tilde{x})$ is be represented as a sum of N radial basis functions (RBFs), each associated with a different center $c$ and weighted by an appropriate coefficient $w_i$ and $\|\cdot\|$ is the notation for a standard Euclidean vector norm. The weights $w_i$ may be computed using the least square method in such a way that the interpolation conditions are met: $Y(x_i) = y_i$. The linear system for the weight coefficients may look like:

$$\begin{bmatrix} \phi_{11} & \phi_{12} & \phi_{1N} \\ \vdots & \vdots & \vdots \\ \phi_{N1} & \phi_{N2} & \phi_{NN} \end{bmatrix} \begin{bmatrix} w_1 \\ \vdots \\ w_N \end{bmatrix} = \begin{bmatrix} y_1 \\ \vdots \\ y_N \end{bmatrix}$$

where $\phi_{ij} = \phi(r_{ij})$ and $r_{ij}$ is the distance between two points (e.g. the distance between two marks). It may be noted that there are as many weight coefficients, i.e. degrees of freedom, as there are interpolation conditions. The resulting system of equations is non-singular (invertible) under very mild conditions and therefore a unique solution exists. For many of the radial basis functions (RBFs) the only restriction is that at least 3 points are not on a straight line.

Numerous choices for RBFs are possible, such as Gaussian basis functions, inverse basis functions, multi-quadratic basis functions, inverse quadratic basis functions, spline degree k basis functions and thin plate spline basis functions. It is noted that also other RBFs are possible. Two major RBF classes are given below: infinitely smooth (whose derivatives exist at each point) and splines (whose derivatives may not exist in some points). Thin plate spline (TPS) refers to a physical analogy involving the bending of a thin sheet of metal. In the physical setting, the deflection is in the z direction, orthogonal to the plane of the thin sheet. In order to apply this idea to the problem of substrate deformation in a lithographic process, the lifting of the plate can be interpreted as a displacement of the x or y coordinates within the plane. TPS has been widely used as a non-rigid transformation model in image alignment and shape matching.

As such, RBF may use a Bending Energy (BE) based regularization, which minimizes a combination of model residuals and model second order derivatives, integrated squared over the infinite plane. Such an approach is described, for example, in WO2022101204A1, which is incorporated herein by reference. In such a BE regularized RBF model, the data is fully fitted with minimal second derivative of model function. This is equivalent to solving this minimization problem for the fit coefficients $c$:

$$c = \arg \min_{c} \|data - \mathbf{K}c\| + \lambda c^T \mathbf{K}c \qquad (1.1)$$

Where $\mathbf{K} = \begin{bmatrix} \phi(r_{11}) & \cdots & \phi(r_{1n}) \\ \vdots & \ddots & \vdots \\ \phi(r_{m1}) & \cdots & \phi(r_{mn}) \end{bmatrix}$ is both the model matrix and the BE regularization matrix and *data* is the measurement data (e.g., alignment data). The model functions $\phi(r_{ij}) = r_{ij}^2 \ln(r_{ij})$ for this model comprise thin plate splines.

The unknown in the above problem is the be regularization parameter $\lambda$, which can be determined in a training phase, e.g., on training or calibration wafers from which first training data or alignment training data and corresponding second training data or overlay (or other placement error such as edge placement error) training data may be measured. The alignment training data $\mathbf{x_{train}}$ may comprise an alignment data training matrix (of size: number of wafers × alignment APD (aligned position deviation) per mark) and the overlay training data $\mathbf{y}_{train}$ may comprise an overlay data training matrix (of size: number of wafers × decorrected overlay APD per overlay target). Decorrected overlay data may be overlay data which has been decorrected for alignment corrections (e.g., this may comprise a difference of the overlay data and the corresponding alignment corrections). A first model matrix $\mathbf{M}_x$ (first model parameters) may comprise a model matrix for the alignment grid and a second model matrix $\mathbf{M}_y$ (second model parameters) may comprise a model matrix for the overlay grid. The regularization parameter $\lambda$ may be optimized in order to minimize (decorrected) overlay:

$$\lambda = \arg \min_{\lambda} \left\| \mathbf{y}_{train}^T - \mathbf{M}_y (\mathbf{M}_x^T \mathbf{M}_x + \lambda \mathbf{K})^{-1} \mathbf{M}_x^T \mathbf{x}_{train}^T \right\| \qquad (1.2)$$

However, as only a single regularization parameter is optimized, the regularization may be sub-optimal. In particular, not all spatial content in alignment and overlay data should necessarily be penalized equally as not all fingerprint components correlate equally between alignment and overlay.

Wafer alignment model mapping (WAMM) is a linear regression method that improves wafer alignment by training on alignment and overlay data. The method suppresses shapes (spatial components) in wafer alignment that do not improve overlay, e.g., those coming from measurement noise, mark deformation or extrapolation errors.

In wafer alignment model mapping (WAMM) the model parameters are modified by applying a linear transformation on them. This linear transformation can be considered as a matrix multiplication: the model parameters are arranged together into a column vector, which is multiplied with a matrix to obtain a new column vector of model parameters. The matrix involved is referred to as the model mapping matrix. The main purpose for this model mapping matrix is to act as a linear filter: it aims to improve the (e.g., overlay) performance of wafer alignment by filtering out spatial components (shapes) which deteriorate overlay and modifying the remaining shapes to further improve overlay. The concept of wafer alignment model mapping is described in WO2017060054 (which is incorporated herein by reference) and will now be briefly described.

In this method, wafer alignment parameters are optimized by mapping them onto overlay parameters via model mapping matrix $\mathbf{M}_{wamm}$, having a size equal to number of parameters squared. The model mapping matrix $\mathbf{M}_{wamm}$ may be determined by:

$$\mathbf{M}_{wamm} = \arg \min_{\mathbf{M}_{wamm}} \left\| \mathbf{y}_{train}^T - \mathbf{M}_y \mathbf{M}_{wamm} (\mathbf{M}_x^T \mathbf{M}_x)^{-1} \mathbf{M}_x^T \mathbf{x}_{train}^T \right\| \qquad (1.3)$$

This model mapping matrix $\mathbf{M}_{wamm}$ can then be used to scale alignment parameters as $\mathbf{M}_{wamm}c$. These scaled parameters are used for fitting the evaluation data. Due to the large number of degrees of freedom in the model mapping matrix, WAMM suffers from overfitting. To improve on this, a cross validation method is used in training. Even with this, somewhere between 100 and 200 training wafers are currently required to properly train the matrix.

To address the above mentioned issues with present regularization strategies and/or WAMM, an improved regularization technique is disclosed herein. In this technique, it is proposed to optimize a plurality of, and preferably all, of the individual regularization matrix elements (regularization parameters), instead of a single regularization parameter $\lambda$, of a regularization for regularizing a fitting of a model to substrate measurement data (e.g., alignment data or overlay data).

The proposed regularization reduces sensitivity to overfitting, although the correction potential for optimal model regularization techniques is less than for WAMM. This is due to the fact that WAMM can amplify model components while regularization can by design only attenuate them. Furthermore, regularization can improve interpolation and extrapolation errors of the model more effectively than WAMM. In practice this means that, compared to WAMM, regularization can obtain similar or better results using fewer training wafers. Note that this regularization concept can be used for other modelling applications also, e.g., modelling a sparse overlay layout with optimal model regularization to achieve similar performance as modelling with a dense overlay layout.

Two specific embodiments will now be described. A first such embodiment may be referred to as Optimal Model Regularization (OMR). This approach may comprise optimizing the full model regularization matrix **K** (or at least a plurality of regularization matrix elements) in order to minimize overlay. As before, the optimization may be performed in a training phase using one or more training wafers from which first training data (e.g., alignment data $\mathbf{x}_{train}$) and related second training data (e.g., overlay data $\mathbf{y}_{train}$) is measured. This embodiment does not require any initial setting up of shapes or correlation analysis for shape-specific regularization parameter determination.

In a specific embodiment, the optimization may comprise:

$$\mathbf{K} = \arg\min_{\mathbf{K}} \left\| \mathbf{y}_{train}^T - \mathbf{M}_y (\mathbf{M}_x^T \mathbf{M}_x + \mathbf{K})^{-1} \mathbf{M}_x^T \mathbf{x}_{train}^T \right\| \qquad (1.4)$$

where **K** is optimized under the constraints of being a positive symmetric matrix, such that only half of regularization matrix elements need to be trained. This will also yield an n x n matrix, enabling eigenvalue decomposition. As before, $\mathbf{M}_x$ is the first model matrix or alignment grid model matrix and $\mathbf{M}_y$ may comprise the second model matrix or overlay grid model matrix.

This model regularization matrix **K** intuitively can be interpreted as attenuating specific shapes which do not improve overlay.

As a purely optional further step, the shapes and their attenuation factors can be found by a suitable decomposition technique such as single value decomposition (SVD) or eigenvalue decomposition of the optimized model regularization matrix **K** matrix. This may be done, for example, for analysis purposes, e.g., to create an orthogonal shape breakdown of the alignment data, overlay data and the overlay correction.

Eigenvalue decomposition to find specific shapes is described (in the context of WAMM) in WO2019001871A1, which is hereby incorporated by reference. Briefly, such a decomposition may comprise decomposing the model regularization matrix **K** to separately determine, e.g., a first deformation that scales differently from a second deformation when mapping between the datasets $\mathbf{x}_{train}$, $\mathbf{y}_{train}$. The decomposing comprises calculating an eigenvalue decomposition for the model regularization matrix **K** and using eigenvalues in an eigenvalue matrix **D** representing different scaling to identify one or more eigenvectors **V** that represent the first deformation. The decomposition may be represented in general as:

$$\mathbf{K} = \mathbf{V} \times \mathbf{D} \times \mathbf{V}^{-1} \qquad (1.5)$$

where **V** can be considered as the shape decomposition matrix representing the deformations, **D** is a diagonal matrix containing the eigenvalues, and **V$^{-1}$** is the matrix that contains the shapes. Note that as the regularization matrix is positive and symmetric, all eigenvalues are positive and the eigenvectors are orthogonal. The inverse of **V** can therefore also be written at the transpose of **V.** This can be regarded as the model regularization matrix **K** being decomposed into shapes, the shapes being scaled with a coordinate transformation and decomposed back again to the original coordinates.

For example, if the model used has a model matrix that is full rank on the sparse alignment grid, the model matrix can be first orthonormalized onto the sparse alignment grid. In doing this, $\mathbf{M}_x^T \mathbf{M}_x$ becomes an identity matrix. As a next step the regularization matrix can be diagonalized using an orthogonal eigenvalue decomposition. It can be appreciated that after model orthonormalization, the regularization matrix is still positive and symmetric as it is multiplied on both sides with the coordinate transformation matrix and its transpose. The remaining modeling scheme after these two base transformations can be directly translated into a diagonal WAMM matrix which comprises diagonal elements equal to $1/(1 + d_{ii})$ where $d_{ii}$ are the eigenvalues of the regularization matrix after model matrix orthonormalization. In a second example, if the used model matrix is not full rank and the model is ill-conditioned on the sparse alignment grid, the model matrix cannot be orthonormalized as it is not full rank. In that case, the regularization can be used and is needed to make the model well-conditioned. A Generalized Singular Value Decomposition (GSVD) can be used to come to a similar conclusion. As input data to the GSVD, the model matrix and the "square root" of the regularization matrix may be used. The "square root" of the regularization matrix can be calculated using for example Cholesky or LDL decomposition. In order to translate this into WAMM, the model may be limited to the relevant subspace such that the subspace model becomes well-conditioned (e.g., is a full rank model matrix) on the alignment layout. This can be done by removing the model dimensions corresponding to zero diagonal elements of the diagonal **C** matrix resulting from the GSVD (**A**=**U**∗**C**∗**X'** and **B**=**V**∗**S**∗**X'**, where **A** is the model matrix and **B** the "square root" of the regularization matrix)

A second embodiment may be referred to as Shape Improvement Based Regularization (SIBR). SIBR may be based on identifying shapes in alignment and/or overlay data which explain most of the variation and using either an optimization on overlay or using a different criterion such as correlation per shape between the first training data and second training data (e.g., obtained as per the OMR embodiment) to determine shape specific regularization factors.

As such, this method may comprise decomposing the model into specific shapes and adjusting a regularization factor on a per-shape basis. The regularization factors can be optimized on overlay or can be adjusted by means of other criteria; for example, the wafer-to-wafer correlation of the shapes between alignment and overlay. This way, the regularization can suppress unwanted shapes that induce larger overlay during wafer alignment modelling.

For the selection of the shapes, various approaches can be used such as a suitable component analysis (e.g., principal component analysis PCA or independent component analysis ICA) or a decomposition technique (e.g., SVD). Taking the example of PCA, this results in orthogonal shapes that may be optimally sorted by overlay contribution strength. BE regularization can be used as a starting point (base regularization) for the regularization to be scaled/optimized, such that the amount of BE regularization may be scaled per shape. The regularization optimization problem may be written as SIBR equation:

$$[\lambda_1, \ldots, \lambda_n] = \arg\min_{\lambda_1,\ldots,\lambda_n} \left\| \mathbf{y}_{train}^T - \mathbf{M}_y \left( \mathbf{M}_x^T \mathbf{M}_x + \mathbf{K}_{\lambda_1,\ldots,\lambda_n} \right)^{-1} \mathbf{M}_x^T \mathbf{x}_{train}^T \right\|^2 \quad (1.6)$$

$$\mathbf{K}_{\lambda_1,\ldots,\lambda_n} = \mathbf{\Lambda}_{\lambda_1,\ldots,\lambda_n}^T \mathbf{R} \mathbf{\Lambda}_{\lambda_1,\ldots,\lambda_n}; \quad \mathbf{\Lambda}_{\lambda_1,\ldots,\lambda_n}^T = \begin{pmatrix} \lambda_1 & 0 & 0 \\ 0 & : & 0 \\ 0 & 0 & \lambda_n \end{pmatrix}$$

where and **R** is a BE regularization. $\Lambda_{\lambda_1,\ldots,\lambda_n}$ may be referred to as the SIBR matrix.

In this equation, it is assumed that the matrices **M**$_x$, **M**$_y$ and **R** have already been transformed to the selected shape base by multiplying them with the appropriate base transformation matrices, i.e., such that each column corresponds to a selected shape.

Figure 4 is a flowchart describing a method to find a regularization matrix **K** for n model shapes. This example uses PCA-based shape selection, bending energy regularization as a starting point and a wafer-to-wafer correlation criterion. Training data 400 (e.g., first training data or alignment data and second training data or overlay data) is obtained, e.g., from exposing and measuring training wafers. At step 410 principal component analysis is employed on the overlay dataset to find orthogonal overlay shapes and rank them by overlay contribution strength. At step 420, the orthogonal shapes are fitted on the overlay dataset and wafer alignment dataset respectively to obtain alignment grid model matrix and overlay grid model matrix. At step 430, wafer-to-wafer correlation (e.g., a correlation metric) between overlay and alignment fitting coefficients is determined.

Step 440 comprises constructing the SIBR matrix $\Lambda_{\lambda_1,\ldots,\lambda_n}$. The regularization may be set per shape based on the correlation metric determined in step 430, for example according to an inverse relationship between level of correlation and level of regulation (i.e., such that highly correlated shapes have a low regularization penalty applied and *vice versa*). The SIBR matrix may therefore comprise:

$$\mathbf{\Lambda}_{\lambda_1,\ldots,\lambda_n} = \begin{pmatrix} f(\mathbf{corr(shape1)}) & 0 & 0 \\ 0 & \ddots & 0 \\ 0 & 0 & f(\mathbf{corr(shapen)}) \end{pmatrix} \quad (1.7)$$

where $f(\cdot)$ is a function which maps correlation to regularization penalty $\lambda_1, \ldots, \lambda_n$ per shape. A simple example of $f$ is $f(x) = 1 - x$.

Finally, at step 450, the model regularization matrix **K** is determined using SIBR matrix $\Lambda_{\lambda_1,\ldots,\lambda_n}$ determined in the preceding step and equation (1.6) described above.

Regardless of the embodiment, once trained, the model regularization matrix **K** may be used to regularize a fitting of a model to substrate measurement data (e.g., alignment or overlay data). The details of such a fitting may depend on the model used, but for example may take the form:

$$c = \arg\min_c \| data - \mathbf{K}c \| + c^T \mathbf{K}c$$

Further embodiments of the invention are disclosed in the list of numbered clauses below:

1. A method for modeling substrate measurement data relating to a substrate in a lithographic process, the method comprising: obtaining substrate measurement data describing spatial variation of a substrate parameter; and fitting a model to said substrate measurement data to obtain a fitted model; wherein said fitting step comprises regularizing the fitting using a plurality of regularization parameters, said plurality of regularization parameters having been individually optimized to penalize spatial components of said substrate measurement data in accordance with their effect on a parameter of interest.

2. A method according to clause 1, wherein said plurality of regularization parameters are comprised within a regularization matrix wherein each regularization matrix element comprises a respective regularization parameter.

3. A method according to clause 1 or 2, wherein said plurality of regularization parameters are operable to apply a level of penalization to spatial components according to an inverse relationship to their effect on the parameter of interest.

4. A method according to any preceding clause, wherein said substrate measurement data comprises overlay data.

5. A method according to any of clauses 1 to 3, wherein said substrate measurement data comprises alignment data.

6. A method according to any preceding clause, wherein said parameter of interest comprises overlay or another placement error metric.

7. A method according to any preceding clause, wherein said individually optimizing comprises:

obtaining first training data relating to one or more training substrates;
obtaining second training data relating to said one or more training substrates; and
individually optimizing said plurality of regularization parameters to obtain said plurality of regularization parameters.

8. A method according to clause 7, wherein said individually optimizing step comprises optimizing said regularization parameters using a cost function relating said first training data and said second training data in terms of first model parameters relating to said first training data, second model parameters relating to said second training data and said plurality of regularization parameters.

9. A method according to clause 7 or 8, wherein said optimizing step comprises optimizing said regularization parameters under a constraint that said regularization parameters comprise a positive symmetric matrix.

10. A method according to any of clauses 7 to 9, further comprising decomposing said regularization parameters into a plurality of spatial components.

11. A method according to clause 10, wherein said decomposing comprises an eigenvalue decomposition or singular value decomposition.

12. A method according to clause 8, wherein said individually optimizing step comprises:

decomposing said first model parameters and said second model parameters into said spatial components;
determining said effect on the parameter of interest of each said spatial component; and
determining a respective regularization parameter for each spatial component based on its determined effect on the parameter of interest.

13. A method according to clause 12, wherein said decomposing step comprises applying a component analysis or decomposition technique on said second training data, and ranking the spatial components by the degree of contribution to said parameter of interest.

14. A method according to clause 12 or 13, wherein said determining a respective regularization parameter for each spatial component comprises applying a respective adjusting or scaling to a base regularization.

15. A method according to clause 14, wherein said base regularization comprises a bending energy regularization.

16. A method according to any of clauses 12 to 15, wherein said determining the effect on the parameter of interest comprises determining a correlation metric describing wafer-to-wafer correlation of said first model parameters and said second model parameters.

17. A method according to any of clauses 11 to 16, wherein said first training data comprises alignment data and said second training data comprises corresponding parameter of interest data.

18. A method according to any preceding clause, comprising performing a subsequent exposure on said substrate based on said fitted model.

19. A computer program comprising program instructions operable to perform the method of any of clauses 1 to 18, when run on a suitable apparatus.

20. A non-transient computer program carrier comprising the computer program of clause 19.

21. A processing arrangement comprising: the non-transient computer program carrier of clause 20; and a processor operable to run the computer program comprised on said non-transient computer program carrier.

22. A lithographic apparatus comprising: an alignment sensor; a patterning device support for supporting a patterning device; a substrate support for supporting a substrate; and the processing arrangement of clause 21.

23. A lithographic apparatus according to clause 22, wherein the alignment sensor is operable to measure the substrate to obtain said substrate measurement data.

24. A lithographic apparatus according to clause 22 or 23, wherein the processing arrangement is further operable to determine corrections for control said patterning device and/or substrate support based on said fitted model.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.. In that regard, the processed "substrates" may be semiconductor wafers, or they may be other substrates, according to the type of product being manufactured.

Although specific reference may be made in this text to embodiments of the invention in the context of a lithographic apparatus, embodiments of the invention may be used in other apparatus. Embodiments of the invention may form part of a patterning device inspection apparatus, a metrology apparatus, or any apparatus that measures or processes an object such as a wafer (or other substrate) or a mask (or other patterning device). These apparatuses may be generally referred to as lithographic tools. Such a lithographic tool may use vacuum conditions or ambient (non-vacuum) conditions.

In the present document, the terms "radiation" and "beam" are used to encompass all types of radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

Although specific reference may have been made above to the use of embodiments of the invention in the context of optical lithography, it will be appreciated that the invention, where the context allows, is not limited to optical lithography and may be used in other applications, for example imprint lithography.

The terms "optimizing" and "optimization" as used herein refers to or means adjusting an apparatus (e.g., a lithography apparatus), a process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

Aspects of the invention can be implemented in any convenient form. For example, an embodiment may be implemented by one or more appropriate computer programs which may be carried on an appropriate carrier medium which may be a tangible carrier medium (e.g. a disk) or an intangible carrier medium (e.g. a communications signal). Embodiments of the invention may be implemented using suitable apparatus which may specifically take the form of a programmable computer running a computer program arranged to implement a method as described herein.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g. within a data center or geographically), or otherwise differently organized. The functionality described herein may be provided by one or more processors of one or more computers executing code stored on a tangible, non-transitory, machine readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

The reader should appreciate that the present application describes several inventions. Rather than separating those inventions into multiple isolated patent applications, these inventions have been grouped into a single document because their related subject matter lends itself to economies in the application process. But the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to costs constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

It should be understood that the description and the drawings are not intended to limit the present disclosure to the particular form disclosed, but to the contrary, the intention is to cover all modifications, equivalents, and alternatives falling within the spirit and scope of the inventions as defined by the appended claims.

Modifications and alternative embodiments of various aspects of the inventions will be apparent to those skilled in the art in view of this description. Accordingly, this description and the drawings are to be construed as illustrative only and are for the purpose of teaching those skilled in the art the general manner of carrying out the inventions. It is to be understood that the forms of the inventions shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the spirit and scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." The term "or" is, unless indicated otherwise, non-exclusive, i.e., encompassing both "and" and "or." Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A method for modeling substrate measurement data relating to a substrate in a lithographic process, the method comprising:

    obtaining substrate measurement data describing spatial variation of a substrate parameter; and
    fitting a model to said substrate measurement data to obtain a fitted model, wherein said fitting step comprises regularizing the fitting using a plurality of regularization parameters, said plurality of regularization parameters having been individually optimized to penalize spatial components of said substrate measurement data in accordance with their effect on a parameter of interest.

2. A method as claimed in claim 1, wherein said plurality of regularization parameters are comprised within a regularization matrix wherein each regularization matrix element comprises a respective regularization parameter.

3. A method as claimed in claim 1 or 2, wherein said plurality of regularization parameters are operable to apply a level of penalization to spatial components according to an inverse relationship to their effect on the parameter of interest.

4. A method as claimed in any preceding claim, wherein said substrate measurement data comprises overlay data and/or alignment data.

5. A method as claimed in any preceding claim, wherein said parameter of interest is overlay or another placement error metric.

6. A method as claimed in any preceding claim, wherein said individually optimizing comprises:

    obtaining first training data relating to one or more training substrates;
    obtaining second training data relating to said one or more training substrates; and
    individually optimizing said plurality of regularization parameters to obtain said plurality of regularization parameters.

7. A method as claimed in claim 6, wherein said individually optimizing step comprises optimizing said regularization parameters using a cost function relating said first training data and said second training data in terms of first model parameters relating to said first training data, second model parameters relating to said second training data and said plurality of regularization parameters.

8. A method as claimed in claim 6 or 7, wherein said optimizing step comprises optimizing said regularization parameters under a constraint that said regularization parameters comprise a positive symmetric matrix.

9. A method as claimed in any of claims 6 to 8, further comprising decomposing said regularization parameters into a plurality of spatial components.

10. A method as claimed in claim 9, wherein said decomposing comprises an eigenvalue decomposition or singular value decomposition.

11. A method as claimed in claim 7, wherein said individually optimizing step comprises:

    decomposing said first model parameters and said second model parameters into said spatial components;
    determining said effect on the parameter of interest of each said spatial component; and
    determining a respective regularization parameter for each spatial component based on its determined effect on the parameter of interest.

12. A method as claimed in claim 11, wherein said decomposing step comprises applying a component analysis or decomposition technique on said second training data, and ranking the spatial components by the degree of contribution to said parameter of interest.

13. A method as claimed in claim 11 or 12, wherein said determining a respective regularization parameter for each spatial component comprises applying a respective adjusting or scaling to a base regularization.

**14.** A method as claimed in any of claims 11 to 13, wherein said determining the effect on the parameter of interest comprises determining a correlation metric describing wafer-to-wafer correlation of said first model parameters and said second model parameters.

**15.** A method as claimed in any of claims 10 to 14, wherein said first training data comprises alignment data and said second training data comprises corresponding parameter of interest data.

Fig. 1

Fig. 2

Fig. 3

Fig. 4

Europäisches
Patentamt

European
Patent Office

Office européen
des brevets

## EUROPEAN SEARCH REPORT

Application Number

EP 23 16 6036

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | WO 2022/101204 A1 (ASML NETHERLANDS BV [NL]) 19 May 2022 (2022-05-19) * paragraphs [0008] – [0012], [0052] – [0059], [0065], [0066] * | 1–15 | INV. G03F9/00 G03F7/00 |
| A | EP 4 134 746 A1 (ASML NETHERLANDS BV [NL]) 15 February 2023 (2023-02-15) * paragraphs [0075] – [0077] * | 1–15 | |
| A | US 2021/011373 A1 (LEE JEONGJIN [KR] ET AL) 14 January 2021 (2021-01-14) * paragraphs [0030] – [0040]; claim 1; figure 8A * | 1–15 | |

TECHNICAL FIELDS
SEARCHED      (IPC)

G03F

The present search report has been drawn up for all claims

| Place of search | Date of completion of the search | Examiner |
|---|---|---|
| Munich | 12 September 2023 | Roesch, Guillaume |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
............................................................
& : member of the same patent family, corresponding
    document

EPO FORM 1503 03.82 (P04C01)

## EP 4 439 181 A1

### ANNEX TO THE EUROPEAN SEARCH REPORT
### ON EUROPEAN PATENT APPLICATION NO.

EP 23 16 6036

This annex lists the patent family members relating to the patent documents cited in the above-mentioned European search report.
The members are as contained in the European Patent Office EDP file on
The European Patent Office is in no way liable for these particulars which are merely given for the purpose of information.

12-09-2023

| Patent document cited in search report | | Publication date | Patent family member(s) | | Publication date |
|---|---|---|---|---|---|
| WO 2022101204 | A1 | 19-05-2022 | CN | 116472500 A | 21-07-2023 |
| | | | KR | 20230107575 A | 17-07-2023 |
| | | | TW | 202236025 A | 16-09-2022 |
| | | | WO | 2022101204 A1 | 19-05-2022 |
| EP 4134746 | A1 | 15-02-2023 | EP | 4134746 A1 | 15-02-2023 |
| | | | TW | 202323998 A | 16-06-2023 |
| | | | WO | 2023016791 A1 | 16-02-2023 |
| US 2021011373 | A1 | 14-01-2021 | KR | 20210007275 A | 20-01-2021 |
| | | | US | 2021011373 A1 | 14-01-2021 |
| | | | US | 2023095808 A1 | 30-03-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 2012218533 A1
- WO 2022101204 A1
- WO 2017060054 A
- WO 2019001871 A1